# EUROPEAN PATENT SPECIFICATION

(11) **EP 3 614 089 B1**
(45) Date of publication and mention of the grant of the patent: **09.04.2025**
(21) Application number: 17906083.5
(22) Date of filing: 31.10.2017
(51) Int. Cl.: F28D 15/04, F28D 15/02, H01L 23/427

(54) **FLAT LOOP HEAT PIPE-BASED VAPOR CHAMBER**
DAMPFKAMMER AUF BASIS EINES FLACHEN SCHLAUFENWÄRMEROHRS
CHAMBRE À VAPEUR FONDÉE SUR TUBE CALOPORTEUR EN BOUCLE PLATE

(30) Priority: 19.04.2017 CN 201710257571
(43) Date of publication of application: 26.02.2020
(73) Proprietor: Beijing Institute of Spacecraft System Engineering, Beijing 100094 (CN); Zhang, Hongxing, Beijing 100094 (CN); Man, Guanglong, Beijing 100094 (CN); Huang, Jinyin, Beijing 100094 (CN); Li, Guoguang, Beijing 100094 (CN)
(72) Inventor: ZHANG, Hongxing, Beijing 100094 (CN); MAN, Guanglong, Beijing 100094 (CN); HUANG, Jinyin, Beijing 100094 (CN); LI, Guoguang, Beijing 100094 (CN)
(74) Representative: Vidon Brevets & Stratégie
(86) International application number: PCT/CN2017/000655
(87) International publication number: WO 2018/191836

(56) References cited:
- WO-A1-2011/130313
- CN-A- 101 487 584
- CN-A- 103 824 826
- CN-A- 105 091 643
- CN-A- 107 131 784
- CN-U- 202 630 760
- US-A1- 2013 233 521
- US-B1- 9 546 826

## Description

### TECHNICAL FIELD

The present invention relates to a vapor chamber, and more particularly, to a vapor chamber based on a flat plate loop heat pipe, and belongs to the technical field of electronic equipment heat dissipation. A standard loop type heat pipe corresponding to the definition of the preamble of claim 1 is known from US 2013233521A.

### BACKGROUND

A loop heat pipe is high-efficiency two-phase heat transfer equipment, and has the characteristics of high heat transfer performance, long-distance heat transfer, good temperature control characteristics, bending arbitrariness, convenience in installation and the like. Due to many incomparable advantages to other sets of heat transfer equipment, the loop heat pipe has a very broad application prospect in many fields such as aviation, aerospace and ground electronic equipment heat dissipation.

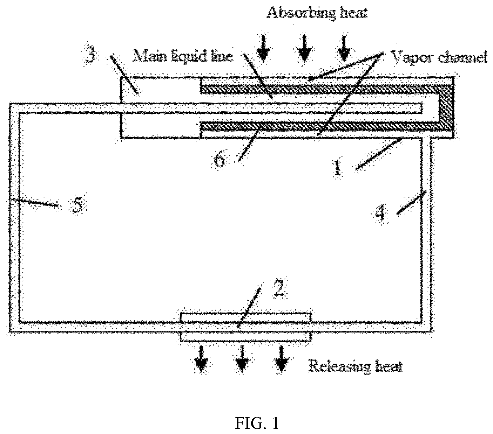

As shown in FIG. 1, the loop heat pipe mainly includes an evaporator 1, a condenser 2, a reservoir 3, a vapor line 4 and a liquid line 5. The whole cycle is as follows: liquid is evaporated on the outer surface of a capillary wick 6 in the evaporator 1, and absorbs heat outside the evaporator 1, and then generated vapor flows from the vapor line 4 to the condenser 2, and releases the heat in the condenser 2 to a heat sink, so as to condense the vapor into liquid, and finally the liquid flows into the reservoir 3 through the liquid line 5. A liquid working fluid in the reservoir 3 is maintained being supplied to the capillary wick in the evaporator 1.

Because of a small installation space of a flat plate loop heat pipe, a flat plate evaporator and a heat source plane are convenient to install. This is a research hotspot and a key application direction in recent years. According to different structures, the flat plate loop heat pipes are mainly divided into two forms. The first form is a disc-shaped flat plate loop heat pipe, and an evaporator is in a disc shape, and the evaporator and a reservoir are separated by a capillary wick. The second form is a rectangular flat plate loop heat pipe, and a reservoir is arranged on one side of an evaporator.

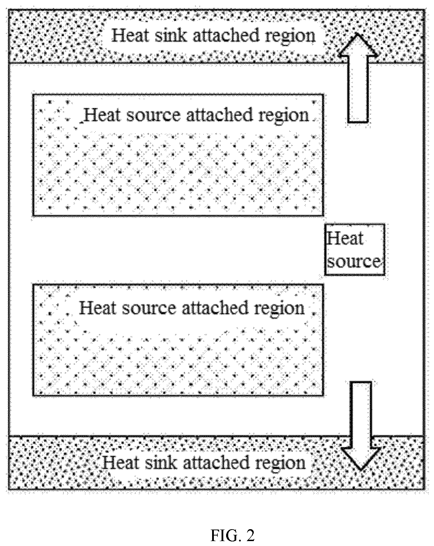

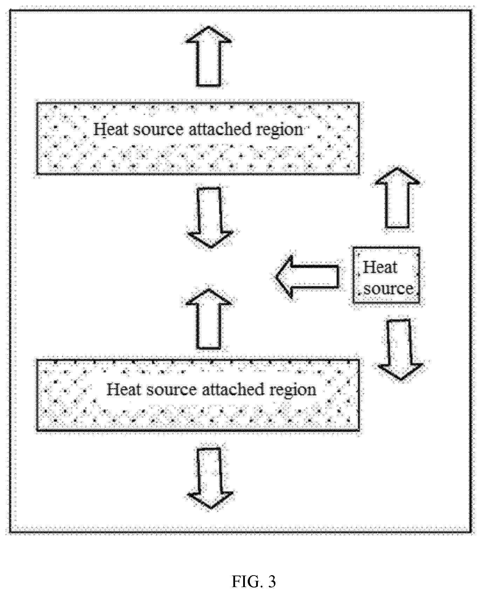

A Vapor Chamber (VC) (which is "Junreban" in Pinyin and is also translated as "Zhengqiqiang" in Pinyin) usually adopts a flat plate structure provided with a capillary wick. After the VC is filled with a working fluid, temperature equalization is realized through a gas-liquid phase change of the working fluid. When the VC is applied, heat sources (a chip or equipment) is attached to the VC, and heat conductive filler is used in an installation interface. There are mainly two application forms:
(1) a heat conductive VC: heat of one or more heat sources is conducted to one side or two sides (heat sink attached region as shown in FIG. 2) of a heat spreading plate, and then the heat is brought away in other heat dissipation ways (water cooling, heat conduction and the like), as shown in FIG. 2; and
(2) a heat spreading VC: heat of one or more heat sources is uniformly spread into other non-heat source regions of the whole VC to play a temperature equalization role and enlarge a heat dissipation area, and then the heat is brought away in other heat dissipation ways such as air cooling or heat conduction, as shown in FIG. 3.

However, the application of the VC has the following problems that: there is a conflict between improvement of the product properties and a requirement on the capillary wick. On one hand, in order to improve certain properties, since reducing of the capillary diameter of the capillary wick can improve the maximum heat transfer capability, increase the ultimate heat flux, improve the anti-overload and anti-gravity working capability and increase the size of the VC, the smaller the capillary diameter of the capillary wick is, the better; and on the other hand, in order to improve part of the properties, it is required that the capillary wick obtains a relatively high permeability by using a relatively large diameter and then increases the size of the VC, that is, increases the flowing length, so that the flowing resistance needs to be reduced, or then decreases the thickness of the VC, that is, decreases the flowing sectional area, so that the flowing resistance needs to be reduced.

### SUMMARY

In view of this, the present invention provides a vapor chamber based on a flat plate loop heat pipe, so as to improve the heat transfer capability, the ultimate heat flux and the anti-overload and anti-gravity working capability of the vapor chamber, increase the size of a heat spreading plate and decrease the thickness of the vapor chamber, and solve a conflicting requirement of the improvement of the properties of the vapor chamber for a diameter size of a capillary wick.

According to the vapor chamber based on the flat plate loop heat pipe, the vapor chamber is attached to heat sources, and is characterized by including: a heat spreading plate and the flat plate loop heat pipe composed of an evaporator, a reservoir and a gas/liquid line. The flat plate loop heat pipe is pre-buried in the heat spreading plate. The evaporator is arranged at a position, attached to a biggest heat source in the heat sources, on the heat spreading plate. The reservoir is used to supply liquid to the evaporator. Positions, attached to other heat sources except the biggest heat source in the heat sources, on the heat spreading plate are used as "heat source attached regions", and positions, not attached to the heat sources, on the heat spreading plate are used as "heat sink attached regions". The gas/liquid line led out from an outlet of the evaporator is cyclically disposed between the "heat source attached regions" and the "heat sink attached regions" on the heat spreading plate, so that a liquid working fluid enters the "heat sink attached regions" after absorbing heat of the "heat source attached regions" and being evaporated into vapor, and a gas working fluid releases heat in the "heat sink attached regions" and is condensed into liquid; and circulation is performed hereby, and the working fluid finally flows back into the reservoir after being condensed by the "heat sink attached regions" into liquid, thus forming a loop.

As a preferable implementation of the present invention, cold sources are arranged in the "heat sink attached regions" on one side or two sides of the heat spreading plate. The gas/liquid line led out from the outlet of the evaporator is cyclically disposed between the "heat sink attached regions" and the "heat source attached regions" on the heat spreading plate.

As a preferable implementation of the present invention, the reservoir is suspended, and is not connected with the heat spreading plate in a heat conduction manner.

As a preferable implementation of the present invention, the evaporator is exposed and directly attached to the biggest heat source in the heat sources.

As a preferable implementation of the present invention, the gas/liquid line is firstly formed by a copper, stainless steel or titanium alloy pipeline sheet metal, and then pre-buried in the heat spreading plate in a gluing or welding manner.

Beneficial effects.
(1) The flat plate loop heat pipe may use a small-diameter capillary wick to provide higher capillary force, and external loops are all bare pipes without capillary wicks, so that the flowing resistance is low; and finally the heat transfer capability, the ultimate heat flux heat dissipation capability and the anti-overload and anti-gravity working capability of the vapor chamber may be improved, the size of the heat spreading plate may be increased, and the thickness of the vapor chamber may be decreased.
(2) Compared with a traditional vapor chamber structure, the vapor chamber of the present invention has the advantages that the thickness of the vapor chamber is decreased by downsizing the evaporator and the line of the flat plate loop heat pipe, so as to satisfy an application occasion with a smaller installation space.

### BRIEF DESCRIPTION OF THE DRAWINGS

FIG. 1 is a structural schematic diagram of a loop heat pipe;
FIG. 2 is a heat conduction schematic diagram of a heat conductive vapor chamber;
FIG. 3 is a heat conduction schematic diagram of a heat spreading vapor chamber;
FIGS. 4 and 5 are heat conduction schematic diagrams of a heat conductive vapor chamber based on a flat plate loop heat pipe; and

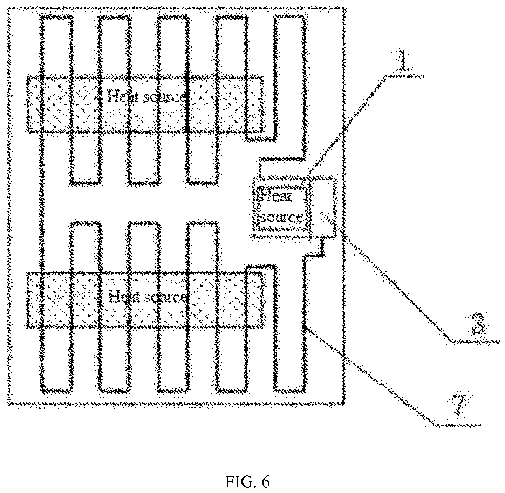

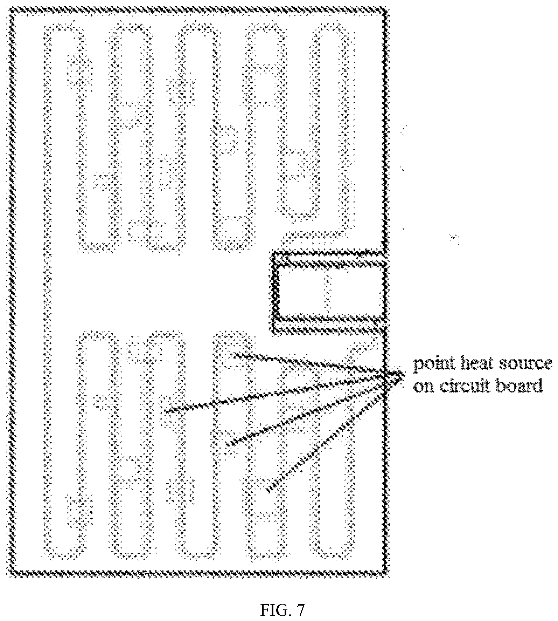

FIGS. 6 and 7 are heat conduction schematic diagrams of a heat spreading vapor chamber based on a flat plate loop heat pipe.
In the drawings, 1: evaporator; 2: condenser; 3: reservoir; 4: vapor line; 5: liquid line; 6: capillary wick; and 7: gas/liquid line

### DETAILED DESCRIPTION

The present invention is described in detail below in combination with accompanying drawings and embodiments.

The present embodiment provides a vapor chamber based on a flat plate loop heat pipe, which may solve a conflicting requirement of the improvement of the properties of the vapor chamber for a diameter size of a capillary wick.

### Embodiment 1: heat conductive vapor chamber

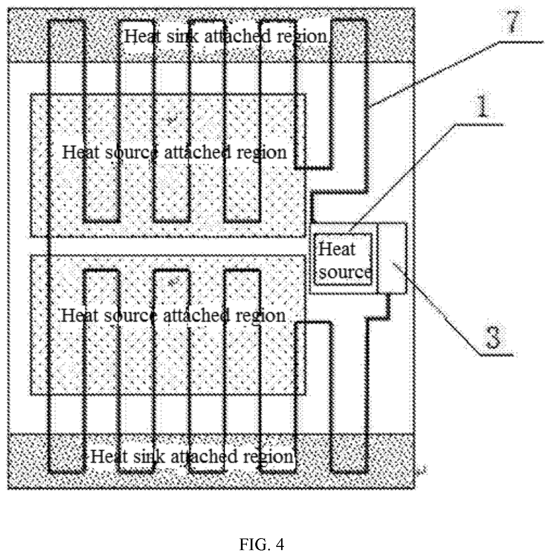

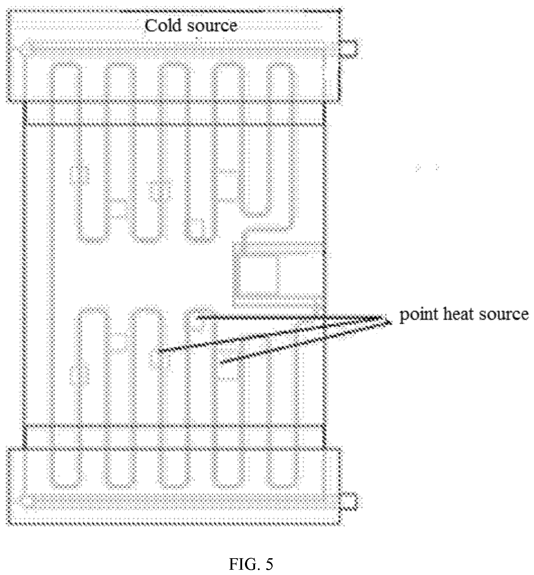

As shown in FIGS. 4 and 5, a flat plate loop heat pipe composed of an evaporator, a reservoir and a gas/liquid line is pre-buried in an aluminum alloy heat spreading plate in a gluing or welding manner to form a vapor chamber based on the flat plate loop heat pipe. The vapor chamber is attached to a circuit board to be subjected to heat dissipation, so that the evaporator of the flat plate loop heat pipe is arranged in a region, attached to a biggest heat source (namely a position with the biggest heat generation amount of the circuit board) of the circuit board, on the vapor chamber. The side, provided with a vapor channel, of the evaporator is attached to the biggest heat source. The evaporator may be pre-buried into the aluminum alloy heat spreading plate, or is only fixed in the aluminum alloy heat spreading plate. The evaporator is exposed and directly attached to the biggest heat source. The liquid reservoir of the flat plate loop heat pipe is suspended, and is not connected with the aluminum alloy heat spreading plate in a heat conduction manner, so as to prevent heat leakage to the reservoir. "Heat sink attached regions" and "heat source attached regions" are arranged on the vapor chamber. The "heat source attached regions" are regions attached to heat sources (except the biggest heat source) on the circuit board, and the "heat sink attached regions" are regions adopting a cooling mode (cold sources) on the back surface of the vapor chamber, as shown in FIG. 5. The gas/liquid line led out from an outlet of the evaporator is cyclically disposed between the "heat sink attached regions" and the "heat source attached regions" on the vapor chamber. The gas/liquid line finally passes through the "heat sink attached regions" and then returns to the reservoir of the flat plate loop heat pipe, as shown in FIG. 4. The gas/liquid line may be firstly formed by a copper, stainless steel or titanium alloy pipeline sheet metal, and then pre-buried in the aluminum alloy heat spreading plate in a gluing or welding manner.

A working principle is that: since the evaporator of the flat plate loop heat pipe is attached to the biggest heat source, liquid is evaporated into vapor in the evaporator, and the vapor flows to the "heat sink attached regions" and releases heat, and then is condensed into liquid. Since the gas/liquid line is cyclically disposed between the "heat source attached regions" and the "heat sink attached regions", a liquid working fluid absorbs heat in the "heat source attached regions" and then is evaporated into vapor, and the vapor releases heat in the "heat sink attached regions" and then is condensed into liquid. This cycle is performed for multiple times, and finally the working fluid flows back into the reservoir after being condensed by the "heat sink attached regions" into the liquid. In such cycle operation, a function of conducting the heat of one or more heat sources to the "heat sink attached regions" is realized.

### Embodiment 2: heat spreading vapor chamber

A main difference from the heat conductive vapor chamber is that: except "heat source attached regions" on the vapor chamber, other regions in no contact with heat sources are all used as "heat sink attached regions". Therefore, a gas/liquid line is cyclically disposed between the "heat source attached regions" and other regions. The working principle of the heat spreading vapor chamber is the same as that of the heat conductive vapor chamber.

## Claims

1. A vapor chamber based on a flat plate loop heat pipe, wherein the vapor chamber is suitable to be attached to heat sources, and is **characterized by** comprising: a heat spreading plate and the flat plate loop heat pipe composed of an evaporator (1), a reservoir (3) and a gas/liquid line (7); the flat plate loop heat pipe is pre-buried in the heat spreading plate; the evaporator is arranged at a position, that, in use, may be attached to a biggest heat source in the heat sources, on the heat spreading plate; the reservoir is used to supply liquid to the evaporator; heat source attached regions are positions that are, in use, suitable to be attached to other heat sources except the biggest heat source in the heat sources, on the heat spreading plate, and heat sink attached regions are positions not intended to be attached, in use, to the heat sources, on the heat spreading plate;
the gas/liquid line led out from an outlet of the evaporator is cyclically disposed between the heat source attached regions and the heat sink attached regions on the heat spreading plate, so that, when in use, a liquid working fluid enters the heat sink attached regions after absorbing heat of the heat source attached regions and being evaporated into vapor, and a gas working fluid releases heat in the heat sink attached regions and is condensed into liquid; and
circulation is performed hereby, and the working fluid finally flows back into the reservoir after being condensed by the heat sink attached regions into liquid, thus forming a loop.

2. The vapor chamber based on the flat plate loop heat pipe according to claim 1, **characterized in that** cold sources are arranged in the heat sink attached regions on one side or two sides of the heat spreading plate; and the gas/liquid line led out from the outlet of the evaporator is cyclically disposed between the heat sink attached regions and the heat source attached regions on the heat spreading plate.

3. The vapor chamber based on the flat plate loop heat pipe according to claim 1 or 2, **characterized in that** the liquid reservoir is suspended, and is not connected with the heat spreading plate in a heat conduction manner.

4. The vapor chamber based on the flat plate loop heat pipe according to claim 1 or 2, **characterized in that** the evaporator is exposed and directly attached to the biggest heat source in the heat sources.

5. The vapor chamber based on the flat plate loop heat pipe according to claim 1 or 2, **characterized in that** the gas/liquid line is firstly formed by a copper, stainless steel or titanium alloy pipeline sheet metal, and then pre-buried in the heat spreading plate in a gluing or welding manner.

6. The vapor chamber based on the flat plate loop heat pipe according to claim 1 or 2, **characterized in that** the heat spreading plate is an aluminum alloy plate.

## Patentansprüche

1. Dampfkammer, die auf einer Flachplattenwärmerohrschleife basiert, wobei die Dampfkammer geeignet ist, an Wärmequellen angebracht zu werden, und **dadurch gekennzeichnet ist, dass** sie umfasst: eine Wärmeverteilerplatte und die Flachplattenwärmerohrschleife, die aus einem Verdampfer (1), einem Reservoir (3) und einer Gas-/Flüssigkeitsleitung (7) besteht; wobei die Flachplattenwärmerohrschleife in der Wärmeverteilerplatte vorvergraben ist; der Verdampfer an einer Position auf der Wärmeverteilerplatte angeordnet ist, die im Betrieb an eine größte Wärmequelle unter den Wärmequellen angeschlossen werden kann; das Reservoir dazu dient, den Verdampfer mit Flüssigkeit zu versorgen; an Wärmequellen angeschlossene Bereiche Positionen sind, die im Betrieb dazu geeignet sind, an andere Wärmequellen als die größte Wärmequelle unter den Wärmequellen auf der Wärmeverteilerplatte angeordnet zu werden, und an Wärmesenken angeschlossene Bereiche Positionen sind, die nicht dazu vorgesehen sind, im Betrieb mit den Wärmequellen auf der Wärmeverteilerplatte verbunden zu werden; die Gas-/Flüssigkeitsleitung, die aus einem Auslass des Verdampfers herausgeführt wird, zyklisch zwischen den an Wärmequellen angeschlossenen Bereichen und den an Wärmesenken angeschlossenen Bereichen auf der Wärmeverteilerplatte angeordnet ist, so dass im Betrieb flüssiges Arbeitsmedium in die an Wärmesenken angeschlossenen Bereiche gelangt, nachdem es die Wärme der an Wärmequellen angeschlossenen Bereiche absorbiert hat und zu Dampf verdampft ist, und ein gasförmiges Arbeitsfluid in die an die Wärmesenken angeschlossenen Bereiche Wärme abgibt und zu Flüssigkeit kondensiert wird; und hierdurch eine Zirkulation durchgeführt wird und das Arbeitsfluid schließlich in das Reservoir zurückfließt, nachdem es durch die an die Wärmesenken angeschlossenen Bereiche zu Flüssigkeit kondensiert wurde, wodurch eine Schleife gebildet wird.

2. Dampfkammer, die auf einer Flachplattenwärmerohrschleife basiert, gemäß Anspruch 1, **dadurch gekennzeichnet, dass** Kältequellen in den an Wärmesenken angeschlossenen Bereichen auf einer Seite oder zwei Seiten der Wärmeverteilerplatte angeordnet sind; und die Gas-/Flüssigkeitsleitung, die aus dem Auslass des Verdampfers herausgeführt wird, zyklisch zwischen den an Wärmesenken angeschlossenen Bereichen und den an Wärmequellen angeschlossenen Bereichen auf der Wärmeverteilerplatte angeordnet ist.

3. Dampfkammer, die auf einer Flachplattenwärmerohrschleife basiert, gemäß Anspruch 1 oder 2, **dadurch gekennzeichnet, dass** das Flüssigkeitsreservoir aufgehängt ist und nicht mit der Wärmeverteilerplatte in einer wärmeleitenden Weise verbunden ist.

4. Dampfkammer, die auf einer Flachplattenwärmerohrschleife basiert, gemäß Anspruch 1 oder 2, **dadurch gekennzeichnet, dass** der Verdampfer der größten Wärmequelle unter den Wärmequellen ausgesetzt und direkt mit ihr verbunden ist.

5. Dampfkammer, die auf einer Flachplattenwärmerohrschleife basiert, gemäß Anspruch 1 oder 2, **dadurch gekennzeichnet, dass** die Gas-/Flüssigkeitsleitung zunächst aus einem Kupfer-, Edelstahl- oder Titanlegierungs-Rohrleitungsblech geformt und dann in die Wärmeverteilerplatte durch Kleben oder Schweißen vorvergraben wird.

6. Dampfkammer, die auf einer Flachplattenwärmerohrschleife basiert, gemäß Anspruch 1 oder 2, **dadurch gekennzeichnet, dass** die Wärmeverteilerplatte eine Platte aus einer Aluminiumlegierung ist.

## Revendications

1. Chambre à vapeur fondée sur un tuyau caloporteur en boucle à plaque plate, dans laquelle la chambre à vapeur est adaptée pour être fixée à des sources de chaleur, et est **caractérisée en ce qu'**elle comprend : une plaque de diffusion de chaleur et le tuyau caloporteur en boucle à plaque plate composé d'un évaporateur (1), d'un réservoir (3) et d'une conduite de gaz/liquide (7) ; le tuyau caloporteur en boucle à plaque plate est préenfoui dans la plaque de diffusion de chaleur ; l'évaporateur est agencé au niveau d'une position qui, en cours d'utilisation, peut être fixée à une source de chaleur la plus grande des sources de chaleur, sur la plaque de diffusion de chaleur ; le réservoir est utilisé pour alimenter l'évaporateur en liquide ;
des régions de fixation de source de chaleur sont des positions qui, en cours d'utilisation, sont adaptées pour être fixées à d'autres sources de chaleur, à l'exception de la source de chaleur la plus grande des sources de chaleur, sur la plaque de diffusion de chaleur, et des régions de fixation de dissipateur thermique sont des positions qui ne sont pas destinées à être fixées, en utilisation, aux sources de chaleur, sur la plaque de diffusion de chaleur ; la conduite de gaz/liquide sortant à partir d'une sortie de l'évaporateur est disposée cycliquement entre les régions de fixation de source de chaleur et les régions de fixation de dissipateur thermique sur la plaque de diffusion de chaleur, de sorte que, lorsqu'elle est utilisée, un fluide de travail liquide pénètre dans les régions de fixation de dissipateur thermique après avoir absorbé de la chaleur des régions de fixation de source de chaleur et avoir été évaporé en vapeur, et un fluide de travail gazeux libère de la chaleur dans les régions de fixation de dissipateur thermique et est condensé en liquide ; et
la circulation est effectuée ici, et le fluide de travail retourne finalement dans le réservoir après avoir été condensé par les régions de fixation de dissipateur thermique en liquide, formant ainsi une boucle.

2. Chambre à vapeur fondée sur le tuyau caloporteur en boucle à plaque plate selon la revendication 1, **caractérisée en ce que** les sources de froid sont agencées dans les régions de fixation de dissipateur thermique sur un côté ou deux côtés de la plaque de diffusion de chaleur ; et la conduite de gaz/liquide sortant à partir de la sortie de l'évaporateur est disposée cycliquement entre les régions de fixation de dissipateur thermique et les régions de fixation de source de chaleur sur la plaque de diffusion de chaleur.

3. Chambre à vapeur fondée sur le tuyau caloporteur en boucle à plaque plate selon la revendication 1 ou 2, **caractérisée en ce que** le réservoir de liquide est suspendu et n'est pas relié à la plaque de diffusion de chaleur de manière à conduire la chaleur.

4. Chambre à vapeur fondée sur le tuyau caloporteur en boucle à plaque plate selon la revendication 1 ou 2, **caractérisée en ce que** l'évaporateur est exposé et fixé directement à la plus grande source de chaleur des sources de chaleur.

5. Chambre à vapeur fondée sur le tuyau caloporteur en boucle à plaque plate selon la revendication 1 ou 2, **caractérisée en ce que** la conduite de gaz/liquide est d'abord formée par une tôle de canalisation en cuivre, en acier inoxydable ou en alliage de titane, puis préenfouie dans la plaque de diffusion de chaleur de manière à être collée ou soudée.

6. Chambre à vapeur fondée sur le tuyau caloporteur en boucle à plaque plate selon la revendication 1 ou 2, **caractérisée en ce que** la plaque de diffusion de chaleur est une plaque en alliage d'aluminium.
